# EUROPÄISCHE PATENTSCHRIFT

(11) **EP 2 205 984 B1**
(45) Veröffentlichungstag und Bekanntmachung des Hinweises auf die Patenterteilung: **13.06.2018**
(21) Anmeldenummer: 08836722.2
(22) Anmeldetag: 24.09.2008
(51) Int. Cl.: G01R 27/02, G01R 27/18, G01R 31/00, G01R 31/02, G01R 31/12

(54) **SCHALTUNGSANORDNUNG ZUR ÜBERWACHUNG EINER ELEKTRISCHEN ISOLATION**
CIRCUIT ARRANGEMENT FOR MONITORING AN ELECTRICAL INSULATION
MONTAGE DESTINÉ À SURVEILLER UNE ISOLATION ÉLECTRIQUE

(30) Priorität: 28.09.2007 DE 102007046483
(43) Veröffentlichungstag der Anmeldung: 14.07.2010
(73) Patentinhaber: Continental Automotive GmbH, 30165 Hannover (DE)
(72) Erfinder: KARRER, Volker, 93055 Regensburg (DE); KUSCHNAREW, Christian, 97076 Würzburg (DE)
(86) Internationale Anmeldenummer: PCT/EP2008/062763
(87) Internationale Veröffentlichungsnummer: WO 2009/043772

(56) Entgegenhaltungen:
- EP-A- 1 265 076
- EP-A1- 1 437 600
- DE-A1- 2 723 019
- DE-A1- 10 304 234
- GB-A- 1 504 181
- US-B2- 6 731 116
- JINGXIN LI ET AL: "Research on Insulation Resistance On-Line Monitoring for Electric Vehicle" ELECTRICAL MACHINES AND SYSTEMS, 2005. ICEMS 2005. PROCEEDINGS OF THE EIGHTH INTERNATIONAL CONFERENCE ON NANJING, CHINA 27-29 SEPT. 2005, PISCATAWAY, NJ, USA,IEEE, Bd. 1, 27. September 2005 (2005-09-27), Seiten 814-817, XP010877521 ISBN: 978-7-5062-7407-4

## Beschreibung

Die Erfindung betrifft eine Schaltungsanordnung zur Überwachung der elektrischen Isolation eines elektrisch leitenden Teils gegenüber einem ersten Pol und einem zweiten Pol eines elektrischen Stromnetzes.

Unter dem Isolationswiderstand eines elektrischen Stromnetzes wird allgemein der ohmsche Widerstandsanteil zwischen elektrischen Leitern untereinander bzw. gegenüber dem Erdpotential verstanden. Da kein idealer Isolator existiert, bildet letztendlich jede Isolierung auch einen ohmschen Widerstand, dessen Wert zwar sehr hoch sein kann, aber trotzdem einen endlichen Wert annimmt. Laut der DIN VDE 0105-100 bzw. DIN VDE 0100-551 ist bei elektrischen Anlagen sowie Hilfsstromkreisen ein Mindest-Isolationswiderstand von 50 bzw. 100 Ω/V erforderlich. Darüber hinaus fordert die ISO 6469 für elektrisch angetriebene Straßenfahrzeuge Isolationswiderstände von 100 Ω/V für Isolationsklasse 1 sowie 500 Ω/V für die Isolationsklasse 2.

Bei der Bestimmung des Isolationswiderstandes eines Stromnetzes ist es oftmals wünschenswert, kontinuierliche Messungen des Isolationswiderstandes vornehmen zu können, um so beispielsweise Personen vor einem "elektrischen Schlag" zu schützen. Mit einer kontinuierlichen Überwachung des Isolationswiderstandes ist es möglich, bereits bei einer vorgegebenen Änderung dieses Widerstandes schnellstmöglich zu reagieren und den Fehler anzuzeigen. Auf diese Weise kann z. B. sichergestellt werden, dass bereits vor einer Zwangsabschaltung eines Stromnetzes ein Fehler entdeckt, bekannt gemacht und schließlich darauf reagiert wird.

Bei der Bestimmung des Isolationswiderstandes eines elektrischen Stromnetzes ist es denkbar, zunächst den Fehlerstrom, also den Anteil des Stroms, der durch die Isolierung fließt, zu bestimmen. Bei bekannter Spannung kann durch einfache Rechnung aus dem ermittelten Fehlerstrom direkt auf den Isolationswiderstand geschlossen werden. Eine solche direkte Messung eines in der Praxis zumeist sehr kleinen Fehlerstromes ist jedoch mehr oder weniger aufwändig und oftmals sehr störanfällig.
In typischen elektrischen Antriebsnetzen, wie sie beispielsweise in Elektro- oder Hybridfahrzeugen zum Einsatz kommen, verursachen Leistungssteller mehr oder weniger große Störungen bzw. Störpotentiale. Bei einer direkten Fehlerstrommessung können solche Störungen zum fehlerhaften Ansprechen einer Isolationsüberwachung führen.

Die Dokumente DE 27 23 019 A1, EP 1 437 600 A1, US 6,731,116 B2 sowie DE 103 04 234 A1 offenbaren Schaltungsanordnungen zur Überwachung des Isolationszustandes von Gleichspannungsnetzen.

Vor diesem Hintergrund liegt der vorliegenden Erfindung die Aufgabe zugrunde, eine Schaltungsanordnung zur Überwachung der elektrischen Isolation eines elektrischen Stromnetzes gegenüber einem leitenden Teil bereitzustellen, welche trotz eines vergleichsweise einfachen Aufbaus eine sichere Detektion von Isolationsfehlern bzw. Fehlerströmen und deren kontinuierliche Überwachung ermöglicht. Insbesondere soll die Erfindung ermöglichen, dass auch unter gestörten Umgebungsbedingungen eine reproduzierbare Überwachung der Isolation erreicht wird. Darüber hinaus soll es möglich sein, einen Fehler sowohl gegen das erste als auch gegen das zweite Potential zu ermitteln und diese Fehler zu unterscheiden.
Die der Erfindung zugrundeliegende Aufgabe wird mit Hilfe einer Schaltungsanordnung mit den im Anspruch 1 angegebenen Merkmalen sowie mit einem Verfahren gemäß Anspruch 10 gelöst.
Vorteilhafte Ausführungsformen der Erfindung sind Gegenstand der abhängigen Ansprüche.
Erfindungsgemäß wird eine Schaltungsanordnung zur Überwachung der elektrischen Isolation eines elektrisch leitenden Teils gegenüber einem ersten Pol und einem zweiten Pol eines elektrischen Stromnetzes derart weitergebildet, - dass zwischen dem elektrisch leitenden Teil einerseits und den beiden Polen andererseits jeweils ein drei zueinander in Serie geschalteten Widerstände aufweisender Spannungsteiler angeordnet ist,
- dass den beiden Spannungsteilern zugeordnet jeweils eine Messeinrichtung zur Messung einer Teilspannung, die über einen der drei Widerstände abfällt, vorgesehen ist,
- und dass den beiden Spannungsteilern zugeordnet jeweils eine Schaltereinrichtung zum wahlweisen Überbrücken von zwei der drei Widerstände vorgesehen ist.
Wesentliches Merkmal der erfindungsgemäßen Lösung ist somit das Vorsehen jeweils eines Spannungsteilers zwischen einem ersten sowie einem zweiten Pol des Stromnetzes und dem Potential des leitenden Teils des zu überwachenden Stromnetzes. Letzteres Potential wird in der Regel zwischen dem ersten Potential und dem zweiten Potential des Stromnetzes liegen (bzw. sich einstellen) und kann, muss aber nicht zwangsweise Erdpotential (oder ein "Massepotential") aufweisen. Sowohl das erste als auch das zweite Potential können veränderlich sein, und können, müssen aber nicht zwangsweise auf Erdpotential oder ein Massepotential bezogen sein.
Bei dem "ersten Pol" und dem "zweiten Pol" des Stromnetzes handelt es sich im Falle eines Gleichstromnetzes um dessen positiven Pol und dessen negativen Pol. Im Falle eines Wechselstromnetzes sind den Polen keine festen "Polaritäten" zuzuordnen bzw. diese Polaritäten (positiv und negativ) wechseln im Betrieb des Stromnetzes.
Der Begriff "Widerstand" ist im Sinne der Erfindung sehr breit als "Impedanz" zu verstehen. Die Widerstände des Spannungsteilers können somit von Widerständen im engeren Sinne (ohmsche Widerstände) gebildet sein, aber alternativ oder zusätzlich auch z. B. von Induktivitäten und/oder Kapazitäten gebildet sein. Wesentlich ist lediglich deren "spannungsteilende Funktion", die insbesondere bei Anwendung der erfindungsgemäßen Überwachung auf ein Wechselstromnetz auch durch Induktivitäten und/oder Kapazitäten realisiert sein kann.
Erfindungswesentlich ist weiterhin, dass den Spannungsteilern jeweils ein Schalter derart zugeordnet ist, dass durch die unterschiedlichen möglichen Zustände der Schalter die beiden Spannungsteiler gezielt verstimmbar sind. Unter einem Verstimmen der Spannungsteiler ist in diesem Fall zu verstehen, dass durch die Veränderung der Schaltzustände der Schalter gezielt die über den jeweiligen Widerständen abfallenden Teilspannungen (Messspannungen) verändert werden, so dass schließlich aus den variierten Messspannungen die Isolationswiderstände des Stromnetzes bestimmt werden können.
Ein besonderer Vorteil der Erfindung besteht darin, dass in vielen Anwendungsfällen eine Spannungsmessung ohnehin vorgesehen ist (z. B. zur Überwachung der Betriebspotentiale bzw. Betriebsspannung des Stromnetzes), so dass in diesen Fällen die Realisierung der Erfindung oftmals nur eine vergleichsweise geringfügige Modifikation einer ohnehin vorhandenen Schaltungsanordnung erfordert. Die Erfindung sieht vor, dass die Spannungsteiler jeweils drei Widerstände aufweisen. Zwei dieser Widerstände sind überbrückbar, indem ein parallel zu diesen zwei Widerständen vorgesehene Schalter geschlossen wird. In Abhängigkeit der Schalterstellung fließt der Strom somit entweder durch die in Reihe geschalteten Widerstände, nämlich bei offener Schalterstellung, oder der Strom fließt durch den die wenigstens zwei Widerstände überbrückenden Schalter.

In einer vorteilhaften Ausführungsform der Erfindung liegt bei jedem der Spannungsteiler, die jeweils zwischen dem elektrisch leitenden Teil und einem ersten (z. B. positiven) bzw. einem zweiten (z. B. negativen) Pol des zu überwachenden Stromnetzes angeordnet sind, die Summe der Widerstandswerte der überbrückbaren Widerstände im Bereich von 30 bis 70% der Gesamtsumme der Widerstandswerte. Werden demnach die zuvor bezeichneten Widerstände aufgrund einer entsprechenden Schalterstellung überbrückt, so wird der Widerstand zwischen dem elektrisch leitenden Teil und dem ersten bzw. zweiten Pol des Stromnetzes auf diesem Strompfad um 30 bis 70% verringert. Diese Größenordnung der "verstimmenden Widerstandsänderung" hat sich in der Praxis als besonders vorteilhaft herausgestellt.

Die vorstehend beschriebene bevorzugte Dimensionierung der Widerstände (wie auch weiter unten noch beschriebene Dimensionierungsregeln bzw. "Widerstandswerte") soll keineswegs auf den Spezialfall von ohmschen Widerständen begrenzt sein. Selbstverständlich können solche Dimensionierungsregeln auch bei Verwendung von Spulen, Kondensatoren etc. als "spannungsteilende Widerstände" vorteilhaft vorgesehen werden. Lediglich beispielhaft sei erwähnt, dass z. B. bei einem Wechselstromnetz die Spannungsteiler jeweils aus einer Reihenschaltung von zumindest zwei Kondensatoren gebildet sein können. In diesem Fall bezeichnet der hier verwendete Begriff "Widerstandswert" den sich aufgrund der Betriebsfrequenz ergebenden Wert des so genannten Wechselstromwiderstands.

Eine weitere ganz spezielle Weiterbildung der Erfindung sieht vor, dass bei wenigstens einem, vorzugsweise bei jedem der Spannungsteiler der für den Abfall der Teilspannung maßgebliche Widerstandswert kleiner als 10% der Gesamtsumme der Widerstandswerte ist. Mit Hilfe dieser technischen Maßnahme wird sichergestellt, dass die zu messende (abfallende) Spannung ebenfalls deutlich kleiner als die an den übrigen Widerständen abfallende Spannung ist. Dies ist insbesondere dann sehr vorteilhaft, wenn die Spannung zwischen den beiden Polen des Stromnetzes relativ groß (z. B. größer als 100 V) ist, weil sich dann die Messspannung einfacher (kostengünstiger) messen lässt. Auch Spannungsänderungen, insbesondere auch bedingt durch veränderte Schaltzustände und/oder einen sich ändernden Isolationswiderstand, lassen sich durch Vorsehen dieser technischen Maßnahme in vielen Anwendungsfällen besonders einfach messen.

Bei einer nächsten speziellen Ausgestaltung der Erfindung ist der Widerstand eines Spannungsteilers, an dem die für eine Auswertung der Messung vorgesehene Teilspannung abfällt, direkt mit dem elektrisch leitenden Teil verbunden. Vorteilhafterweise ist diese Art der Verschaltung sowohl bei dem zwischen dem elektrisch leitenden Teil und dem ersten Pol als auch bei dem zwischen dem elektrisch leitenden Teil und dem zweiten Pol angeordneten Spannungsteiler realisierbar. Insbesondere ist es damit vorteilhaft ermöglicht, dass das leitende Teil ein gemeinsames Eingangspotential für die beiden Messeinrichtungen bildet.

Bei dem elektrisch leitenden Teil, das über den jeweiligen Spannungsteiler mit dem ersten bzw. zweiten Pol des Stromnetzes elektrisch leitend verbunden ist, handelt es sich beispielsweise um ein Innenraum-, ein Karosserie- oder Rahmenteil eines Kraftfahrzeugs. Es kann ein Teil innerhalb des Stromnetzes darstellen, dessen Potential z. B. in der Mitte zwischen dem Potential des ersten, z. B. positiven Pols und des zweiten, z. B. negativen Pols liegt. Grundsätzlich kann auch das Potential der Fahrzeugkarosserie bzw. des Fahrzeugrahmens im Bereich zwischen den Potentialen des ersten und zweiten Pols variieren, in der Regel stellen diese Bauteile eines Fahrzeugs bezogen auf das Stromnetz allerdings die Masse dar und verfügen somit normalerweise über ein Potential "0".

Ganz allgemein ist es von besonderer Bedeutung, dass elektrisch leitende Teile, die von Personen berührt werden können, nicht über ein übermäßiges elektrisches Potential verfügen. Es sollte stets sicher gestellt sein, dass Personen, die ein entsprechendes Teil (z. B. Bauteil in einem Kraftfahrzeug oder in einem Gebäude) berühren und z. B. mit ihrem Körper oder einem Körperteil das Bauteil erden, keinem unzulässig hohen Stromfluss ausgesetzt sind, also keinen elektrischen Schlag erleiden.

Aus diesem Grund muss insbesondere bei Fahrzeugen, deren Karosserien vornehmlich aus elektrisch leitfähigen Materialien bestehen, sicher gestellt sein, dass eine ausreichende Isolation zwischen dem Stromnetz eines Fahrzeugs und den Teilen der Karosserie besteht bzw. der Isolationswiderstand des Stromnetzes ausreichend hoch ist. In Abhängigkeit des Isolationswiderstandes eines Stromnetzes variiert letztendlich auch das elektrische Potential einer Fahrzeugkarosserie und ist nicht zwangsläufig mit dem Erdpotential "0" gleichzusetzen. Ebenso ist es denkbar, dass die Spannung zwischen dem elektrisch leitenden Teil, z. B. einer Fahrzeugkarosserie, und dem ersten Pol ungleich der Spannung zwischen dem elektrisch leitenden Teil und dem zweiten Pol ist.

Die erfindungsgemäße Schaltung lässt zu, dass das im Stromnetz zwischen den beiden Spannungsteilern (am "leitenden Teil") vorhandene Potential zwischen dem Potential des ersten Pols und dem Potential des zweiten Pols variabel gleitet.

In einer ganz besonders geeigneten Ausführungsform der Erfindung verfügen die Messeinrichtungen jeweils über einen Differenzmessverstärker, dessen Differenzeingängen die jeweilige Teilspannung bzw. Messspannung zugeführt wird. Hierbei handelt es sich bei der Teilspannung wiederum vorzugsweise um die an einem kleineren von mehreren überbrückbaren Widerständen abfallende Spannung. Mit dieser technischen Maßnahme wird auch die Erfassung vergleichsweise kleiner Spannungsdifferenzen auf sichere Weise ermöglicht.

Für die Verwendung in den Spannungsteilern eignen sich insbesondere Widerstände, bei denen die Gesamtsumme der Widerstandswerte größer als 1 MΩ ist. Damit ergibt sich für die meisten Anwendungsfälle z. B. eine hinreichend bzw. akzeptabel kleine Verlustleistung (aufgrund des über die Spannungsteiler fließenden Stroms).

Eine ganz spezielle Weiterbildung der Erfindung sieht vor, dass bei jedem der Spannungsteiler die Gesamtsumme der Widerstandswerte kleiner als 10 MΩ ist. Dies ist z. B. vorteilhaft im Hinblick auf die Zuverlässigkeit bzw. Genauigkeit der Erfassung einer mangelhaften Isolation.

Um die Auslegung, Herstellung sowie messtechnische Anbindung der erfindungsgemäßen Schaltungsanordnung zu vereinfachen, ist es in vielen Fällen ferner vorteilhaft, die beiden Spannungsteiler im Wesentlichen identisch auszubilden, also z. B. Bauteile, die über nahezu identische physikalische Eigenschaften verfügen, einzusetzen. In einer speziellen Ausführungsform sind die beiden Spannungsteiler identisch ausgebildet.

Eine weitere vorteilhafte Gestaltung der Erfindung zeichnet sich dadurch aus, dass die beiden Messeinrichtungen jeweils eingangsseitig und/oder ausgangsseitig ein Filter aufweisen. Diese z. B. zur Glättung der jeweiligen Messspannung vorgesehenen Filter stellen sicher, dass die messtechnische Erfassung von Spannungen bzw. Spannungsdifferenzen auch bei vergleichsweise kleinen Werten mit hoher Genauigkeit erfolgen kann. Darüber hinaus kann durch entsprechende Filter die Beeinflussung durch etwaige Störsignale vermieden oder zumindest stark verringert werden.

Vorteilhafterweise ist zwischen einem Ausgang der Messverstärker und dem elektrisch leitenden Teil, also an dem Punkt des Stromnetzes, dessen Potential zwischen den Potentialen der beiden entgegengesetzten Pole variabel gleitet, ein Widerstand angeordnet. In diesem Zusammenhang ist es ebenfalls denkbar, zwischen einem Ausgang der Messverstärker und dem elektrisch leitenden Teil alternativ oder in Ergänzung zu dem erwähnten Widerstand einen Kondensator vorzusehen. Eine entsprechende technische Lösung eignet sich besonders im Zusammenhang mit der Erfindung, wenn zwischen einem Ausgang der Messverstärker und dem elektrisch leitenden Teil ein Kondensator in Reihe geschaltet angeordnet wird. Auch ist es denkbar, zwischen dem elektrisch leitenden Teil und jeweils einem Verstärkereingang der Messverstärker einen Kondensator vorzusehen.

Um eine vergleichsweise einfache Schaltungsanordnung zu realisieren, ist es besonders vorteilhaft, wenn die beiden Messeinrichtungen im Wesentlichen identisch ausgebildet sind. Hieraus folgt, dass eine besonders geeignete Ausführungsform der Erfindung über zwei, jeweils nahezu identische Messeinrichtung verfügt, wobei diese jeweils einen Messverstärker sowie mit diesem verschaltete Kondensatoren und/oder Widerstände aufweisen können.

Die erfindungsgemäße Schaltungsanordnung ist insbesondere geeignet für den Einsatz in Fahrzeugen, insbesondere Straßenfahrzeugen, die über einen elektrischen Fahrantrieb verfügen. Bei derartigen Fahrzeugen kann es sich z. B. um Elektrofahrzeuge wie Elektroautos, Brennstoffzellenbusse oder auch sogenannte Trolleybusse, also Busse mit einer Energieversorgung mittels Oberleitung, handeln. Eine bevorzugte Verwendung der Erfindung ergibt sich für so genannte Hybridfahrzeuge wie z. B. Hybridautos oder Hybridbusse.

Fahrzeuge, die über einen elektrischen Fahrantrieb verfügen, zeichnen sich insbesondere dadurch aus, dass die zwischen dem ersten und dem zweiten Pol des elektrischen Antriebsnetzes auftretenden Spannungen betriebsmäßig zumindest zeitweise größer als 60 Volt und somit lebensgefährlich sind.

Die erfindungsgemäße Schaltungsanordnung zur Überwachung der elektrischen Isolation eignet sich zum Beispiel, um in einem Fahrzeug des Individualverkehrs oder des öffentlichen Personenverkehrs sicherzustellen, dass der Fahrer bzw. etwaige Fahrgäste bei Berührung elektrisch leitendender Teile nicht übermäßig hohen elektrischen Spannungen ausgesetzt werden.

Eine spezielle Ausführungsform der Erfindung sieht vor, dass die Schaltungsanordnung in einem Gleichstromnetz eingesetzt wird.
Neben einer Schaltungsanordnung zur Überwachung der elektrischen Isolation eines elektrisch leitenden Teils gegenüber einem ersten und einem zweiten Pol eines elektrischen Stromnetzes betrifft die Erfindung auch ein entsprechendes Verfahren zur Überwachung der Isolation bzw. eines Isolationswiderstandes. Das erfindungsgemäße Verfahren zeichnet sich dadurch aus,
- dass die Spannungen zwischen dem elektrisch leitenden Teil einerseits und den beiden Polen andererseits jeweils mittels eines drei zueinander in Serie geschalteten Widerstände aufweisenden Spannungsteilers geteilt werden,
- dass an den beiden Spannungsteilern jeweils eine der über einen (R3, R6) der drei Widerstände (R1, R2, R3, R4, R5, R6) abfallenden Teilspannungen gemessen wird,
- und dass bei der Überwachung betriebsmäßig zwei der Widerstände mittels einer Schaltereinrichtung zeitweise überbrückt wird.
Mit Hilfe des erfindungsgemäßen Verfahrens wird auf einfache Weise sichergestellt, dass der Isolationswiderstand eines Stromnetzes trotz Störeinflüssen kontinuierlich und mit hoher Genauigkeit überwacht werden kann.
In einer ganz besonderen Weiterbildung des erfindungsgemäßen Verfahrens werden während der Überwachung des elektrischen Isolationswiderstandes eines Stromnetzes betriebsmäßig, also z. B. automatisch, bevorzugt in einem zyklischen Ablauf, verschiedene Schaltzustände der Schaltereinrichtungen durchlaufen. Die entsprechenden Zyklen können z. B. in einer entsprechenden Steuereinheit hinterlegt sein. Hierbei eignet sich beispielsweise die Hinterlegung in einem zentralen Fahrzeugführungsrechner.

Sollte bei der Überwachung des Isolationswiderstandes festgestellt werden, dass der Isolationswiderstand zumindest an einer Stelle des Stromnetzes unter einen zulässigen Grenzwert fällt, so kann eine entsprechende Fehlermeldung generiert und in einer zentralen Rechnereinheit abgespeichert und/oder ein entsprechendes Warnsignal abgesetzt werden. Damit kann auf vorteilhafte Weise z. B. der Fahrzeugführer eines Fahrzeugs, z. B. eines Fahrzeugs mit elektrischem Fahrantrieb (insbesondere z. B. Hybridfahrzeug), über das Auftreten eines unzulässig niedrigen Isolationswiderstandes bzw. eines zu hohen Fehlerstroms informiert werden. Auch kann (z. B. bei Feststellung der Erfüllung vorbestimmter Kriterien durch die Auswerteeinheit) eine Zwangsabschaltung des Stromnetzes bewirkt werden.

Die Erfindung wird nachfolgend anhand eines Ausführungsbeispiels mit Bezug auf die beigefügte Zeichnung weiter beschrieben. Es stellt dar:

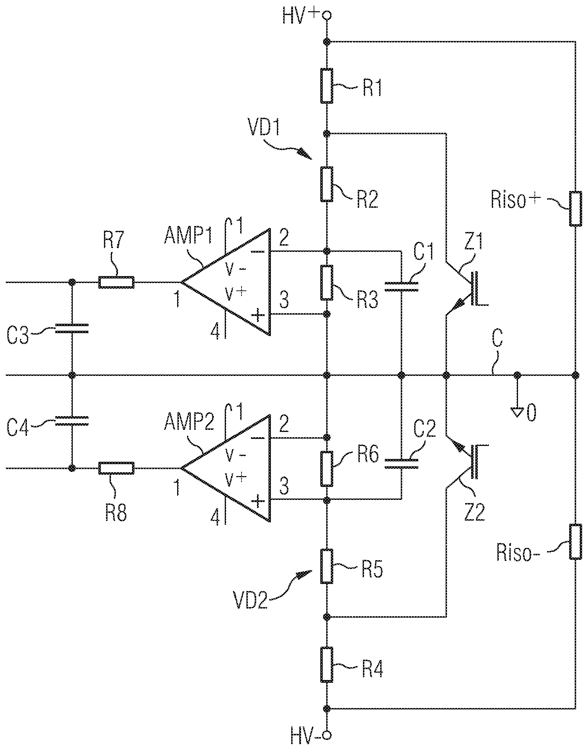

- Fig. 1: eine Schaltungsanordnung zur Überwachung der elektrischen Isolation bei einem Hybridfahrzeug.

Gemäß des Ausführungsbeispiels wird die Schaltungsanordnung in einem Fahrzeug mit Hybridantrieb, also einem Fahrzeug, bei dem ein Verbrennungsmotor mit einem Elektromotor parallel oder seriell als Fahrantrieb angeordnet sind, eingesetzt.

Bei dem Fahrzeug soll der Isolationswiderstand zwischen einem elektrisch leitenden Karosserie- bzw. Rahmenteil C und jeweils einem positiven Pol HV+ sowie einem negativen Pol HVdes Fahrzeugstromnetzes überwacht werden. Im Betrieb des Stromnetzes treten zwischen HV+ und HV- typischerweise Spannungen in der Größenordnung einiger 10² V auf, die durch eine entsprechende Batterie (nicht dargestellt) bereitgestellt werden.

Zwischen dem Karosserieteil C und dem positiven Pol HV+ ist ein Spannungsteiler VD1 angeordnet. Ein weiterer Spannungsteiler VD2 ist zwischen dem Karosserieelement C und dem negativen Pol HV- angeordnet.

Die Anordnung der Spannungsteiler VD1 und VD2 zeichnet sich weiterhin dadurch aus, dass diese mit Hilfe von Schaltern Z1 bzw. Z2 jeweils teilweise überbrückbar sind. So ist der Schalter Z1 dem Spannungsteiler VD1 und der Schalter Z2 dem Spannungsteiler VD2 zugeordnet.

Der Spannungsteiler VD1 besteht im dargestellten Beispiel aus Widerständen R1, R2 und R3, die zwischen dem elektrisch leitenden Karosserieelement C und dem positiven Pol HV+ des Stromnetzes in Reihe geschaltet angeordnet sind. Der Schalter Z1 ist bezüglich der Widerstände derart angeordnet, dass er einerseits elektrisch leitend mit dem Karosserieelement C und andererseits mit einem Schaltungsknoten zwischen den Widerständen R1 und R2 verbunden ist. Die Widerstände R2 und R3 sind je nach Schalterstellung überbrückbar. In Abhängigkeit der Schalterstellung von Z1 fließt der Strom somit wahlweise durch die Widerstände R2 und R3 (offene Schalterstellung) oder über den Schalter Z1 (geschlossene Schalterstellung).

Zwischen den mittels des Schalters Z1 überbrückbaren Widerständen R2 und R3 und dem positiven Pol HV+ des Stromnetzes ist der weitere Widerstand R1 in Reihe geschaltet.

Von den drei in Reihe geschalteten Widerständen R1, R2 und R3 verfügen die Widerstände R1 und R2 im dargestellten Beispiel jeweils über einen (ohmschen) Widerstandswert von 1 MΩ, während der Widerstand R3 einen Widerstandswert von 1 kΩ aufweist. Eine derartige Dimensionierung der Widerstände stellt sicher, dass die am Widerstand R3 abfallende Teilspannung, die auch als Messspannung zu bezeichnen ist, deutlich kleiner als die jeweils an den Widerständen R1 und R2 abfallenden Spannungen ist.

Parallel zu dem Widerstand R3 ist ein Kondensator C1 angeordnet, der einerseits leitend mit der Fahrzeugkarosserie C und andererseits mit einem Schaltungsknoten zwischen R2 und R3 verbunden ist. Der Kondensator C1 dient insbesondere der Glättung des Messsignals und somit auch der Verringerung des Einflusses von Störgrößen.

Die beiden Anschlüsse des Widerstandes R3, zwischen denen, wie beschrieben, nur eine kleine Teil- oder Messspannung abfällt, sind mit den beiden Eingängen eines Differenzmessverstärkers AMP1 verbunden, durch den die am Widerstand R3 abfallende Messspannung verstärkt wird. Der Ausgang des Differenzverstärkers AMP1 ist über eine Reihenschaltung aus einem Widerstand R7 und einem weiteren Kondensator C3 mit der Fahrzeugkarosserie C verbunden. Das Ausgangssignal des Verstärkers AMP1 wird einer (nicht dargestellten) Auswerteeinrichtung zugeführt, die z. B. einen Teil des erwähnten zentralen Fahrzeugführungsrechners bilden kann.

Neben der zwischen der Fahrzeugkarosserie C und dem positiven Pol HV+ vorgesehenen Messeinrichtung mit dem Spannungsteiler VD1 ist in der Figur schematisiert der Strompfad des Fehlerstroms dargestellt, der durch die Größe eines Isolationswiderstandes Riso+ bestimmt wird.

Tritt ein Isolationsfehler im Stromnetz auf, so sinkt der Isolationswiderstand Riso+ und der Fehlstrom steigt entsprechend an. Da es sich in dem vorliegenden Ausführungsbeispiel um die Überwachung eines Stromnetzes in einem elektrisch angetriebenen Straßenfahrzeug handelt, fordert die ISO 6469 je nach Isolationsklasse Isolationswiderstände von 100 Ω/V (Isolationsklasse 1) bis 500 Ω/V (Isolationsklasse 2). Mit Hilfe der in der Figur dargestellten Schaltungsanordnung wird insbesondere eine kontinuierliche Überwachung des Isolationswiderstandes ermöglicht, so dass bei Unterschreitung eines im zentralen Fahrzeugführungsrechner hinterlegten Grenzwerts eine entsprechende Fehlermeldung sowie ein Warnsignal an den Fahrer übermittelt werden.

In Ergänzung zum Absetzen einer Fehlermeldung bzw. eines Warnsignals ist es ebenfalls denkbar, bei einem Fahrzeug in Abhängigkeit des Betriebszustandes, der Größe und/oder der Geschwindigkeit einer Grenzwertüberschreitung eine automatische Abschaltung des Stromnetzes durchzuführen. Bei einem Fahrzeug sollte allerdings gewährleistet sein, dass ein Betrieb der sicherheitsrelevanten Fahrzeugkomponenten trotz der Abschaltung des Stromnetzes, zumindest für eine gewisse Zeitspanne möglich ist.

Bei der Beschreibung der Figur wurde bislang nur auf den im Bereich zwischen der Fahrzeugkarosserie C und dem positiven Pol HV+ angeordneten Teil der Schaltungsanordnung detailliert eingegangen. Um Wiederholungen zu vermeiden, wird an dieser Stelle darauf hingewiesen, dass der Teil der Schaltungsanordnung, der sich zwischen der Fahrzeugkarosserie C und dem negativen Pol HV- befindet im Vergleich zu dem zuvor beschriebenen Teil identisch ausgebildet ist und auch identische Bauteile verwendet werden. In der Figur stellt somit die Fahrzeugkarosserie C in gewisser Weise eine Spiegelachse dar.

Wesentlich an dem zwischen der Fahrzeugkarosserie C und dem negativen Pol HV- des Stromnetzes befindlichen Teil der Schaltungsanordnung ist wiederum, dass durch Widerstände R4, R5 und R6 ein Spannungsteiler VD2 gebildet ist, der mittels des Schalters Z2 teilweise überbrückbar ist. R6 dient als Messwiderstand und besitzt im Vergleich zu den anderen Widerständen R4 und R5 einen vergleichsweise kleinen Widerstandswert. Die am Widerstand R6 abfallende Spannung wird über einen Differenzmessverstärker AMP2 verstärkt und ausgewertet. Im dargestellten Beispiel sind die Schalter Z1 und Z2 als Transistoren (FETs)ausgebildet.

Mit der dargestellten Schaltungsanordnung wird sowohl ein im Fahrzeugstromnetz gegen positives Potential als auch ein gegen negatives Potential auftretender Isolationsfehler feststellbar und unterscheidbar. Wie es weiter unten noch beschrieben wird, ist auch der Fall feststellbar, in welchem die Isolation sowohl gegen positives Potential als auch gegen negatives Potential (allgemein: gegen das erste Potential und gegen das zweite Potential) fehlerhaft ist.

In Bezug auf die beschriebene und in der Figur dargestellte Schaltungsanordnung werden im Folgenden drei unterschiedliche Betriebszustände und deren Erfassung durch die Auswerteeinheit näher erläutert.

In einem ersten Betriebszustand ("ordnungsgemäße Isolation") sind beide Isolationswiderstände Riso+ und Riso- sehr groß (idealserweise "unendlich groß", in der Praxis z. B. größer als 10 MΩ).

In diesem Fall wird sich am Karosserieteil C ein Potential einstellen, welches im Wesentlichen lediglich von der Dimensionierung der beiden Spannungsteiler VD1 und VD2 abhängt. Im dargestellten Beispiel wird dieses Potential aufgrund der identischen Ausbildung der beiden Spannungsteiler somit in der Mitte zwischen den Potentialen HV+ und HV- liegen. Wenn die Potentiale HV+ und HVbeispielsweise von einer Batterie mit einer Batteriespannung von 400 V bereitgestellt werden, so ergeben sich für HV+, C, HV- die Potentiale +200 V, 0 V bzw. -200 V.

In diesem Normalfall sind die an den Widerständen R3 sowie R6 abfallenden Spannungen gleich groß. Dieser Umstand wird durch die den beiden Messverstärkern AMP1 und AMP2 nachgeordnete Auswerteeinheit erfasst.

Ein weiteres Charakteristikum dieses ersten, ordnungsgemäßen Betriebszustands besteht darin, dass auch bei einer wahlweisen Verstimmung der beiden Spannungsteiler VD1 und VD2 durch Schließen wenigstens eines der Schalter Z1 und Z2 das sich am Karosserieteil C einstellende Potential im Wesentlichen lediglich von der Dimensionierung der Spannungsteiler VD1 und VD2 (sowie dem konkreten Schalterzustand) abhängt. Auch dieser Umstand wird von der Auswerteeinheit erfasst, um den ersten Betriebzustand eindeutig zu identifizieren.

Die Überwachung liefert somit das Ergebnis, dass die Grenzwerte in Bezug auf die Isolationswiderstände (Riso+ und Riso-) des Stromnetzes nicht unterschritten werden, so dass ein weiterer Betrieb des Stromnetzes sowie des elektrischen Fahrantriebs unbedenklich ist.

Bei einem zweiten Betriebszustand ("Riso+ oder Riso- zu klein") liegt entweder zwischen der Fahrzeugkarosserie und dem positiven Pol HV+ oder zwischen der Fahrzeugkarosserie und dem negativen Pol HV- ein unzulässig kleiner Isolationswiderstand (bzw. unzulässig großer, über Riso+ oder Riso- fließender Fehlerstrom) auf.

In diesem Betriebszustand ergibt sich bereits bei geöffneten Schaltern Z1 und Z2 eine Verschiebung des elektrischen Potentials der Fahrzeugkarosserie C in Abhängigkeit der Fehlerstromgrößen entweder in Richtung des Potentials am positiven Pol HV+ oder in Richtung des Potentials am negativen Pol HV-. In diesem Fall sind folglich die über die Differenzmessverstärker AMP1, AMP2 erfassten Teilspannungen, die an den Widerständen R3 bzw. R6 abfallen, unterschiedlich groß. Dieser Umstand lässt sich problemlos von der Auswerteeinheit erfassen und führt zu einer entsprechenden Fehlermeldung bzw. anderen Sicherheitsmaßnahmen (z. B. Abschaltung des Stromnetzes).

An dieser Stelle ist jedoch anzumerken, dass für eine eindeutige Erfassung dieses zweiten Betriebszustands, bei welchem entweder Riso+ oder Riso- unzulässig klein ist, wenigstens noch eine Auswertung bei einem weiteren Schalterzustand der Schalter Z1 und Z2 erforderlich ist. Eine Abweichung der an R3 abfallenden Messspannung von der an R6 abfallenden Messspannung bei geöffneten Schaltern Z1 und Z2 kann nämlich auch durch einen dritten Betriebszustand ("Riso+ und Riso- zu klein") hervorgerufen werden.

Eine Unterscheidung zwischen dem zweiten Betriebszustand und dem dritten Betriebszustand (bzw. dem ersten und dem dritten Betriebszustand) ist jedoch problemlos durch eine Auswertung von Messspannungen für verschiedene Schaltzustände der Schalter Z1 und Z2 möglich. Durch eine gezielte Verstimmung der beiden Spannungsteiler VD1 und VD2 durch Schließen wenigstens eines der Schalter Z1 und Z2 wird sich zwar für beide Betriebszustände das an der Fahrzeugkarosserie C sich einstellende Potential verschieben. Das Ausmaß der Potentialverschiebung am Karosserieteil C ist jedoch für den zweiten Betriebszustand ein anderes als für den dritten Betriebszustand. Über die für verschiedene Schaltzustände erfassten Teilspannungen können in der Auswerteeinheit somit beide Fehlerströme bzw. beide Isolationswiderstände Riso+ und Riso- ermittelt werden. Bei Überschreitung eines Grenzwerts kann eine Fehlermeldung sowie ein Warnsignal generiert werden, welches Auskunft über die Art und das Ausmaß des Isolationsfehlers geben kann.

Die Schaltungsanordnung ist somit geeignet, beide Isolationswiderstände zuverlässig zu überwachen und darüber hinaus sowohl einen Fehler gegen negatives als auch gegen positives Potential zu bestimmen (Auch die Kombination dieser beiden Fehler ist qualitativ und quantitativ bestimmbar).

In einer Ausführungsform eines Überwachungsverfahrens werden die Schalter nacheinander geschlossen und geöffnet, indem zunächst der Schalter Z1 geschlossen und wieder geöffnet wird, bevor der Schalter Z2 geöffnet und wieder geschlossen wird.

Die Schließzeit der Schalter beträgt z. B. jeweils etwa 1 min. Es ergibt sich dann ein Überwachungszyklus bestehend aus drei Überwachungsphasen (1. Phase: beide Schalter geöffnet; 2. Phase: einer der Schalter geschlossen; 3. Phase: der andere der Schalter geschlossen). Während jeder Phase werden die an den Widerständen R3 und R6 abfallenden Spannungen erfasst.

Durch eine entsprechende Auswertung dieser Messspannungen lässt sich der momentan vorliegende Betriebszustand zweifelsfrei erfassen und auch die Größe der Fehlerströme bzw. der Isolationswiderstände Riso+ und Riso- in einfacher Weise bestimmen.

Die für diese Bestimmung z. B. geeignete Anwendung des ohmschen Gesetzes bzw. der Kirchhoffregeln an dem aus den Widerständen R1 bis R6, Riso+ und Riso- bestehenden Widerstandsnetzwerk ist dem Fachmann wohlbekannt und bedarf daher hier keiner näheren Erläuterung.

In diesem Zusammenhang ist anzumerken, dass die erfindungsgemäße Überwachungsmethode keineswegs voraussetzt, dass der elektrische Widerstand der verwendeten Schaltereinrichtungen (hier: Schalter Z1 und Z2, z. B. als Schalttransistoren ausgebildet) im geschlossenen Schaltzustand einen besonders kleinen elektrischen Widerstandswert ("Ein-Widerstand") besitzen. Vielmehr ist es ohne weiteres möglich, dass eine betreffende Schaltereinrichtung einen nennenswerten Ein-Widerstand besitzt bzw. in Reihe zu einem Widerstandselement angeordnet ist. Wesentlich für die Isolationsüberwachung in diesem Fall ist lediglich, dass der entsprechende Ein-Widerstand bekannt ist und bei der Auswertung der Messspannungen zur Ermittlung der Fehlerströme bzw. Isolationswiderstände berücksichtigt wird.

In diesem Zusammenhang ist ferner anzumerken, dass in der Praxis nicht für alle Schaltzustände der Schalter Z1 und Z2 jeweils beide Messspannungen (an R3 und R6) unbedingt der Auswertung zugeführt werden müssen. Im dargestellten Ausführungsbeispiel liegt z. B. am Widerstand R3 bzw. den Eingängen des Differenzverstärkers AMP1 nur dann eine Spannung an, wenn der Schalter Z1 geöffnet ist, wohingegen am Widerstand R6 bzw. den Eingängen des Differenzverstärkers AMP2 nur dann eine Spannung anliegt, wenn der Schalter Z2 geöffnet ist. Dementsprechend erübrigt sich bei der dargestellten Schaltungsanordnung z. B. eine Messung der an R3 abfallenden Spannung bei geschlossenem Schalter Z1 (zumindest wenn der Ein-Widerstand von Z1 vernachlässigbar gegenüber der Summe der Widerstände R2 und R3 ist).

Zusammenfassend werden die erfassten Messspannungen für verschiedene Schaltzustände an eine Auswerteeinheit übertragen, wo anhand der veränderten Messspannungen die tatsächlichen Isolationswiderstände bzw. die eventuell vorhandenen Fehlerströme berechnet werden. Auf diese Weise ist es möglich, sowohl den Fehler gegen das Potential am ersten (z. B. positiven) Pol als auch gegen das Potential am zweiten (z. B. negativen) Pol zu ermitteln und diese Fehler zuverlässig voneinander zu unterscheiden.

Bei einer kontinuierlichen Überwachung der Isolationswiderstände bzw. der Fehlerströme in einem Stromnetz eines Hybridfahrzeugs erfolgt einerseits die Erfassung und Auswertung der Messspannungen und andererseits die Ansteuerung der Schalter Z1 und Z2 bevorzugt vollautomatisch in einem vorgebbaren Zyklus. Im Fahrzeugführungsrechner werden diesbezüglich die Messzeitpunkte, die Dauer der Messungen, die Zeitpunkte, zu denen die Schalter Z1 und Z2 geöffnet oder geschlossen werden, und auch die Zeitspannen, über die die Schalter jeweils geöffnet bzw. geschlossen bleiben, hinterlegt. Vorzugsweise läuft ein Messzyklus jeweils über eine Zeitdauer im Bereich von etwa 1 ms bis mehrere Minuten (z. B. einige Sekunden) und wird nach einer vorgebbaren Betriebsdauer des Fahrzeugs wiederholt.

Abweichend von dem oben erwähnten Überwachungsverfahren mit drei verschiedenen Überwachungsphasen (Schaltzuständen) könnte als eine weitere Überwachungsphase auch noch der vierte Zustand vorgesehen sein, bei welchem beide Schalter Z1 und Z2 geschlossen sind (etwa zur Bereitstellung eines weiteren, redundanten Messergebnisses).

Die beschriebene Schaltungsanordnung sowie das Verfahren zur Überwachung der Isolation eines Stromnetzes stellen somit eine Möglichkeit dar, den Isolationswiderstand eines Fahrzeugs sowie die eventuell auftretenden Fehler auf verhältnismäßig einfache Weise mit hoher Genauigkeit zu bestimmen. Auch eine kontinuierliche Überwachung lässt sich so auf einfache Weise realisieren.

## Patentansprüche

1. Schaltungsanordnung zur Überwachung der elektrischen Isolation eines elektrisch leitenden Teils (C) gegenüber einem ersten Pol (HV+) und einem zweiten Pol (HV-) eines elektrischen Stromnetzes,
**dadurch gekennzeichnet,**
**dass** zwischen dem elektrisch leitenden Teil (C) einerseits und den beiden Polen (HV+, HV-) andererseits jeweils ein drei zueinander in Serie geschalteten Widerstände (R1, R2, R3, R4, R5, R6) aufweisender Spannungsteiler (VD1, VD2) angeordnet ist,
**dass** den beiden Spannungsteilern (VD1, VD2) zugeordnet jeweils eine Messeinrichtung zur Messung einer Teilspannung vorgesehen ist, die über einen (R3, R6) der drei Widerstände (R1, R2, R3, R4, R5, R6) abfällt,
und **dass** den beiden Spannungsteilern (VD1, VD2) zugeordnet jeweils eine Schaltereinrichtung (Z1, Z2) zum wahlweisen Überbrücken von zwei (R2, R3, R5, R6) der drei Widerstände (R1, R2, R3, R4, R5, R6) vorgesehen ist.

2. Schaltungsanordnung nach Anspruch 1, **dadurch gekennzeichnet, dass** bei jedem der Spannungsteiler (VD1, VD2) der für den Abfall der Teilspannung maßgebliche Widerstand (R3, R6) elektrisch direkt mit dem leitenden Teil (C) verbunden ist.

3. Schaltungsanordnung nach einem der vorangehenden Ansprüche, **dadurch gekennzeichnet, dass** die Messeinrichtungen jeweils einen Differenzmessverstärker (AMP1, AMP2) aufweisen, dessen Differenzeingängen die jeweilige Teilspannung zugeführt wird.

4. Schaltungsanordnung nach einem der vorangehenden Ansprüche, **dadurch gekennzeichnet, dass** die beiden Messeinrichtungen jeweils eingangsseitig und/oder ausgangsseitig ein Filter (C1, C2, C3, R7, C4, R8) aufweisen.

5. Schaltungsanordnung nach Anspruch 4, **dadurch gekennzeichnet, dass** zwischen einem Ausgang der Messverstärker (AMP1, AMP2) und dem leitenden Teil (C) ein Widerstand (R7, R8) angeordnet ist.

6. Schaltungsanordnung nach Anspruch 4 oder 5, **dadurch gekennzeichnet, dass** zwischen einem Ausgang der Messverstärker (AMP1, AMP2) und dem leitenden Teil (C) ein Kondensator (C3, C4) angeordnet ist.

7. Schaltungsanordnung nach einem der Ansprüche 4 bis 6, **dadurch gekennzeichnet, dass** zwischen einem Ausgang der Messverstärker (AMP1, AMP2) und dem leitenden Teil (C) ein Widerstand (R7, R8) und ein Kondensator( C3, C4) in Reihe geschaltet angeordnet sind.

8. Schaltungsanordnung nach einem der Ansprüche 4 bis 7, **dadurch gekennzeichnet, dass** zwischen dem leitenden Teil (C) und jeweils einem Verstärkereingang der Messverstärker (AMP1, AMP2) ein Kondensator (C1, C2) angeordnet ist.

9. Schaltungsanordnung nach einem der vorangehenden Ansprüche, **dadurch gekennzeichnet, dass** das elektrisch leitende Teil (C) ein Chassisteil eines Fahrzeugs ist.

10. Verfahren zur Überwachung der elektrischen Isolation eines elektrisch leitenden Teils (C) gegenüber einem ersten Pol (HV+) und einem zweiten Pol (HV-) eines elektrischen Stromnetzes,
**dadurch gekennzeichnet,**
**dass** die Spannungen zwischen dem elektrisch leitenden Teil (C) einerseits und den beiden Polen (HV+, HV-) andererseits jeweils mittels eines drei zueinander in Serie geschalteten Widerstände (R1, R2, R3, R4, R5, R6) aufweisenden Spannungsteilers (VD1, VD2) geteilt werden,
**dass** an den beiden Spannungsteilern (VD1, VD2) jeweils eine der über einen (R3, R6) der drei Widerstände (R1, R2, R3, R4, R5, R6) abfallenden Teilspannungen gemessen wird,
und **dass** bei der Überwachung betriebsmäßig zwei (R2, R3, R5, R6) der Widerstände (R1, R2, R3, R4, R5, R6) mittels einer Schaltereinrichtung (Z1, Z2) zeitweise überbrückt wird.

## Claims

1. Circuit arrangement for monitoring the electrical insulation of an electrically conductive part (C) with respect to a first pole (HV+) and a second pole (HV-) of an electrical power grid,
**characterized in that**
a voltage divider (VD1, VD2) having three resistors (R1, R2, R3, R4, R5, R6) connected in series with one another is arranged in each case between the electrically conductive part (C) on the one hand and the two poles (HV+, HV-) on the other hand,
**in that** a measurement device associated with the two voltage dividers (VD1, VD2) is provided in each case for measuring a partial voltage dropped across one (R3, R6) of the three resistors (R1, R2, R3, R4, R5, R6),
and **in that** a switch device (Z1, Z2) associated with the two voltage dividers (VD1, VD2) is provided in each case for selectively bypassing two (R2, R3, R5, R6) of the three resistors (R1, R2, R3, R4, R5, R6).

2. Circuit arrangement according to Claim 1, **characterized in that**, in each of the voltage dividers (VD1, VD2), the resistor (R3, R6) that is essential for the drop of the partial voltage is electrically connected to the conductive part (C) directly.

3. Circuit arrangement according to either of the preceding claims, **characterized in that** the measurement devices each have a differential measurement amplifier (AMP1, AMP2), the differential inputs of which are supplied with the respective partial voltage.

4. Circuit arrangement according to one of the preceding claims, **characterized in that** the two measurement devices each have a filter (C1, C2, C3, R7, C4, R8) on the input side and/or on the output side.

5. Circuit arrangement according to Claim 4, **characterized in that** a resistor (R7, R8) is arranged between an output of the measurement amplifier (AMP1, AMP2) and the conductive part (C).

6. Circuit arrangement according to Claim 4 or 5, **characterized in that** a capacitor (C3, C4) is arranged between an output of the measurement amplifier (AMP1, AMP2) and the conductive part (C).

7. Circuit arrangement according to one of Claims 4 to 6, **characterized in that** a resistor (R7, R8) and a capacitor (C3, C4) are arranged connected in series between an output of the measurement amplifier (AMP1, AMP2) and the conductive part (C).

8. Circuit arrangement according to one of Claims 4 to 7, **characterized in that** a capacitor (C1, C2) is arranged between the conductive part (C) and in each case one amplifier input of the measurement amplifier (AMP1, AMP2).

9. Circuit arrangement according to one of the preceding claims, **characterized in that** the electrically conductive part (C) is a chassis part of a vehicle.

10. Method for monitoring the electrical insulation of an electrically conductive part (C) with respect to a first pole (HV+) and a second pole (HV-) of an electrical power grid,
**characterized in that**
the voltages between the electrically conductive part (C) on the one hand and the two poles (HV+, HV-) on the other hand are each divided by means of a voltage divider (VD1, VD2) having three resistors (R1, R2, R3, R4, R5, R6) connected in series with one another,
**in that**, in each case, one of the partial voltages dropped across one (R3, R6) of the three resistors (R1, R2, R3, R4, R5, R6) is measured at the two voltage dividers (VD1, VD2),
and **in that**, during the monitoring, two (R2, R3, R5, R6) of the resistors (R1, R2, R3, R4, R5, R6) are temporarily bypassed in operation-dependent fashion by means of a switch device (Z1, Z2).

## Revendications

1. Arrangement de circuit destiné à surveiller l'isolation électrique d'une partie électriquement conductrice (C) par rapport à un premier pôle (HV+) et un deuxième pôle (HV-) d'un réseau électrique,
**caractérisé**
**en ce qu'**un diviseur de tension (VD1, VD2) possédant trois résistances (R1, R2, R3, R4, R5, R6) branchées en série les unes avec les autres est respectivement disposé entre la partie électriquement conductrice (C) d'une part et les deux pôles (HV+, HV-) d'autre part,
**en ce qu'**un dispositif de mesure destiné à mesurer une tension partielle qui chute aux bornes de l'une (R3, R6) des trois résistances (R1, R2, R3, R4, R5, R6) est respectivement associé aux deux diviseurs de tension (VD1, VD2),
et **en ce qu'**un dispositif à commutateur (Z1, Z2) destiné à court-circuiter au choix deux (R2, R3, R5, R6) des trois résistances (R1, R2, R3, R4, R5, R6) est respectivement associé aux deux diviseurs de tension (VD1, VD2).

2. Arrangement de circuit selon la revendication 1, **caractérisé en ce que** sur chacun des diviseurs de tension (VD1, VD2), la résistance (R3, R6) qui détermine la chute de la tension partielle est directement reliée électriquement à la partie conductrice (C).

3. Arrangement de circuit selon l'une des revendications précédentes, **caractérisé en ce que** les dispositifs de mesure possèdent respectivement un amplificateur de mesure différentiel (AMP1, AMP2), la tension partielle respective étant acheminée aux entrées différentielles de celui-ci.

4. Arrangement de circuit selon l'une des revendications précédentes, **caractérisé en ce que** les deux dispositifs de mesure possèdent respectivement un filtre (C1, C2, C3, R7, C4, R8) du côté de l'entrée et/ou du côté de la sortie.

5. Arrangement de circuit selon la revendication 4, **caractérisé en ce qu'**une résistance (R7, R8) est disposée entre une sortie de l'amplificateur de mesure (AMP1, AMP2) et la partie conductrice (C).

6. Arrangement de circuit selon la revendication 4 ou 5, **caractérisé en ce qu'**un condensateur (C3, C4) est disposé entre une sortie de l'amplificateur de mesure (AMP1, AMP2) et la partie conductrice (C).

7. Arrangement de circuit selon l'une des revendications 4 à 6, **caractérisé en ce qu'**une résistance (R7, R8) et un condensateur (C3, C4) sont disposés en étant branchés en série entre une sortie de l'amplificateur de mesure (AMP1, AMP2) et la partie conductrice (C).

8. Arrangement de circuit selon l'une des revendications 4 à 7, **caractérisé en ce qu'**un condensateur (C1, C2) est disposé entre la partie conductrice (C) et respectivement une entrée d'amplificateur de l'amplificateur de mesure (AMP1, AMP2).

9. Arrangement de circuit selon l'une des revendications précédentes, **caractérisé en ce que** la partie conductrice (C) est une partie de châssis d'un véhicule.

10. Procédé de surveillance de l'isolation électrique d'une partie électriquement conductrice (C) par rapport à un premier pôle (HV+) et un deuxième pôle (HV-) d'un réseau électrique,
**caractérisé en ce**
**que** les tensions entre la partie électriquement conductrice (C) d'une part et les deux pôles (HV+, HV-) d'autre part sont respectivement divisées au moyen d'un diviseur de tension (VD1, VD2) possédant trois résistances (R1, R2, R3, R4, R5, R6) branchées en série les unes avec les autres,
**qu'**une des tensions partielles qui chutent aux bornes de l'une (R3, R6) des trois résistances (R1, R2, R3, R4, R5, R6) est respectivement mesurée au niveau des deux diviseurs de tension (VD1, VD2),
et **que** lors de la surveillance, deux (R2, R3, R5, R6) des résistances (R1, R2, R3, R4, R5, R6) sont temporairement court-circuitées fonctionnellement au moyen d'un dispositif à commutateur (Z1, Z2).
